# EUROPEAN PATENT APPLICATION

(11) **EP 2 934 074 A1**
(43) Date of publication of application: **21.10.2015**
(21) Application number: 13863567.7
(22) Date of filing: 15.11.2013
(51) Int. Cl.: H05K 3/00

(54) **WIRING SUBSTRATE AND PRODUCTION METHOD THEREFOR**

(30) Priority: 11.12.2012 JP 2012270434; 17.01.2013 JP 2013006194
(71) Applicant: NGK SPARK PLUG CO., LTD., Nagoya-shi, Aichi 467-8525 (JP)
(72) Inventor: MAEDA, Shinnosuke, Nagoya-shi Aichi 467-8525 (JP)
(74) Representative: Intès, Didier Gérard André
(86) International application number: PCT/JP2013/080903
(87) International publication number: WO 2014/091869

(57) **Abstract**

A wiring substrate includes an insulation substrate, a through hole, an upper-surface-side land conductor, a lower-surface-side land conductor, and a through hole conductor. The insulation substrate includes a first insulation layer, a second insulation layer, and a glass fiber layer provided between the first and second insulation layers. The through hole has a diameter which decreases from the upper surface of the insulation substrate toward the interior thereof, which becomes smallest at the glass fiber layer, and which increases from the glass fiber layer toward the lower surface of the insulation substrate. The upper-surface-side land conductor and the lower-surface-side land conductor respectively cover the upper-surface-side and lower-surface-side openings of the through hole. The through hole conductor is formed in the through hole. The upper-surface-side opening of the through hole has a diameter larger than that of the lower-surface-side opening of the through hole, and the upper-surface-side land conductor has a diameter larger than that of the lower-surface-side land conductor.

## Description

### CROSS REFERENCE TO RELATED APPLICATIONS

This international application claims priority to Japanese Patent Application No. 2012-270434 filed December 11, 2012, and Japanese Patent Application No. 2013-6194 filed January 17, 2013 in the Japanese Patent Office, both of which are incorporated herein by reference in their entirety.

### TECHNICAL FIELD

The present invention relates to a wiring substrate having through holes provided therein, and to a method for producing the wiring substrate.

### BACKGROUND ART

There has been known a multilayer wiring substrate including build-up layers provided on opposite surfaces of a support substrate, each of the build-up layers being formed through alternate stacking of insulation layers and conductor layers. In such a multilayer wiring substrate, the support substrate has a through hole penetrating therethrough, and a conductor layer formed on the wall surface of the through hole, whereby the build-up layer formed on the upper surface of the support substrate is electrically connected to the build-up layer formed on the lower surface of the support substrate.

Hitherto, there has been known a technique for providing a through hole by separately applying a laser beam to the upper and lower surfaces of a substrate, the through hole having tapered portions whose tops face each other (see, for example, Patent Document 1). This technique can fill a through hole having high aspect ratio with a conductor without generating voids in the through hole.

### PRIOR ART DOCUMENT

### PATENT DOCUMENT

Patent Document 1: Japanese Patent Application Laid-Open (*kokai*) No. 2003-46248

### SUMMARY OF THE INVENTION

### PROBLEMS TO BE SOLVED BY THE INVENTION

However, the technique described in Patent Document 1 may cause a problem that the through hole provided on the upper surface side of the substrate is misaligned with the through hole provided on the lower surface side thereof, since these through holes are separately provided through laser beam application.

Therefore, in consideration of the aforementioned misalignment, an upper-surface-side land for covering the opening of the upper-surface-side through hole and a lower-surface-side land for covering the opening of the lower-surface-side through hole must be formed so as to have a large size. This may cause a reduction in wiring density in a build-up layer.

In one preferred aspect of the present invention, there is provided a technique for improving the wiring density of a wiring substrate having a through hole, as well as a technique for providing, in a substrate, a through hole having tapered portions whose tops face each other through application of a laser beam to one surface of the substrate.

### MEANS FOR SOLVING THE PROBLEMS

In one aspect of the present invention, there is provided a wiring substrate comprising an insulation substrate, a through hole, an upper-surface-side land conductor, a lower-surface-side land conductor, and a through hole conductor. The insulation substrate has a structure including a first insulation layer, a second insulation layer, and a glass fiber layer provided between the first and second insulation layers. One of opposite surfaces of the insulation substrate is defined as the upper surface, and the other of the opposite surfaces is defined as a lower surface. The through hole is provided in the insulation substrate, and has a diameter which decreases from the upper surface of the insulation substrate toward the interior thereof, which becomes smallest at the glass fiber layer, and which increases from the glass fiber layer toward the lower surface of the insulation substrate. The upper-surface-side land conductor is formed so as to cover an upper-surface-side opening of the through hole. The lower-surface-side land conductor is formed so as to cover a lower-surface-side opening of the through hole. The through hole conductor is formed in the through hole so as to electrically connect the upper-surface-side land conductor with the lower-surface-side land conductor. The upper-surface-side opening of the through hole has a diameter larger than that of the lower-surface-side opening of the through hole, and the upper-surface-side land conductor has a diameter larger than that of the lower-surface-side land conductor.

In the wiring substrate according to this aspect of the present invention, the insulation substrate has a structure in which the glass fiber layer is provided between the first insulation layer and the second insulation layer. Therefore, a through hole can be provided in the insulation substrate through the below-described method.

Firstly, there is formed a layered structure having a structure in which a metal layer and the insulation substrate are sequentially stacked. Then, a laser beam is applied to a surface of the layered structure on which the metal layer is not provided (hereinafter the surface may be referred to as "laser beam application surface"), to thereby provide, in the second insulation layer, a through hole having a diameter which decreases from the laser beam application surface toward the interior of the insulation substrate. This is because the amount of thermal energy received from the laser beam applied to the laser beam application surface decreases toward the interior of the insulation substrate. The previous and following description pertains to the case where, among the first and second insulation layers, the second insulation layer is provided on the side toward the laser beam application surface.

Since the glass fiber layer is provided between the first insulation layer and the second insulation layer, a region between the first and second insulation layers (hereinafter the region may be referred to as a "glass fiber region") is less likely to be melted through laser beam application, as compared with the first and second insulation layers. Therefore, the rate at which the through hole is provided (in a stacking direction) in the layered structure by laser beam application is lower in the glass fiber region than in the second insulation layer.

Thus, the diameter of a portion of the through hole penetrating the second insulation layer decreases from the laser beam application surface toward the interior of the insulation substrate; i.e., the portion assumes a truncated conical shape, by the time the through hole provided by laser beam application penetrates the glass fiber region.

Thereafter, when the laser beam applied via the laser beam application surface penetrates the glass fiber region, the laser beam is applied, through the second insulation layer and the glass fiber region, to the first insulation layer, whereby the through hole is provided in the first insulation layer from the glass fiber region toward the metal layer until the laser beam penetrates the first insulation layer.

When the laser beam applied via the laser beam application surface penetrates the first insulation layer, the laser beam is applied, through the second and first insulation layers, to the metal layer. Therefore, the thermal energy from the laser beam applied to the metal layer is conducted to the first insulation layer via the metal layer, whereby the diameter of a portion of the through hole penetrating the first insulation layer decreases from the metal layer toward the interior of the insulation substrate; i.e., the portion assumes a truncated conical shape. This is because the amount of thermal energy received from the metal layer decreases toward the interior of the insulation substrate.

Then, laser beam application is terminated before penetration of the laser beam through the metal layer. This is because when the laser beam penetrates the metal layer, the amount of thermal energy received by the metal layer from the laser beam becomes considerably lower than that before penetration of the laser beam through the metal layer.

Thereafter, the metal layer may be removed, or the metal layer may be employed for forming a conductor layer on the insulation substrate.

As described above, the through hole---whose diameter decreases from the first surface of the layered structure toward the interior thereof and increases from the interior toward the second surface of the layered structure---can be provided by laser beam application through the first surface of the layered structure.

Thus, even when the through hole has a high aspect ratio, the through hole can be filled with a through hole conductor without generating voids in the through hole. Furthermore, an upper-surface-side portion of the through hole, which is located above the glass fiber layer, is not misaligned with respect to a lower-surface-side portion of the through hole, which is located below the glass fiber layer. Therefore, since the aforementioned misalignment is not required to be taken into consideration, neither the upper-surface-side land conductor for covering the opening of the upper-surface-side portion of the through hole, nor the lower-surface-side land conductor for covering the opening of the lower-surface-side portion of the through hole is required to be formed to have a large size.

When the upper surface of the insulation substrate serves as the aforementioned laser beam application surface, the diameter of the opening of the upper-surface-side portion of the through hole becomes larger than that of the opening of the lower-surface-side portion of the through hole. This is because, since the laser beam is applied through the upper surface of the insulation substrate, the amount of thermal energy received by the upper surface is larger than that received by the lower surface.

The diameter of each land conductor, which covers the corresponding opening of the through hole, is adjusted to become slightly larger than that of the opening of the through hole. Thus, the diameter of the lower-surface-side land conductor can be made smaller than that of the upper-surface-side land conductor.

As described above, there is no requirement to take into consideration misalignment between the upper-surface-side land conductor and lower-surface-side land conductor provided on the insulation substrate. Furthermore, since the diameter of the lower-surface-side land conductor can be made smaller than that of the upper-surface-side land conductor, wiring density can be improved on the lower surface side of the insulation substrate.

In another aspect of the present invention, the wiring substrate comprises a plurality of through holes, an upper-surface-side land conductor corresponding to each of the through holes, and a lower-surface-side land conductor corresponding to each of the through holes, wherein, on the lower surface of the insulation substrate, a wire is formed between at least two adjacent lower-surface-side land conductors. Thus, a region between the two lower-surface-side land conductors can be effectively employed for wiring, and wiring density can be improved on the lower surface side of the insulation substrate.

In still another aspect of the present invention, the wiring substrate comprises, on the lower surface side of the insulation substrate, a connection terminal for connecting the wiring substrate to an IC chip. In the wiring substrate according to this aspect, since the diameter of the lower-surface-side land conductor is smaller than that of the upper-surface-side land conductor, the degree of freedom of wiring layout is higher on the lower surface side of the insulation substrate than on the upper surface side thereof. Therefore, the degree of integration of connection terminals---which are provided on the wiring substrate of this aspect for connecting the wiring substrate to an electronic component---is more likely to be improved on the lower surface side of the insulation substrate than on the upper surface side thereof. When an IC chip is mounted on the first surface of the wiring substrate of this aspect (i.e., the wiring substrate having a through hole penetrating between the upper surface and the lower surface of the insulation substrate), generally, another wiring substrate is connected to the second surface, and the degree of integration of connection terminals is higher on the surface on which the IC chip is mounted.

In yet another aspect of the present invention, the through hole has an upper-surface-side portion located above the glass fiber layer, and a lower-surface-side portion located below the glass fiber layer; and the upper-surface-side portion has a cross-sectional area larger than that of the lower-surface-side portion. Thus, since the upper-surface-side portion of the through hole has a heat capacity larger than that of the lower-surface-side portion of the through hole, heat generated in an electronic component mounted on the lower surface side is readily released, via the through hole, toward the upper surface of the insulation substrate, and the heat release performance of the electronic component can be improved.

In yet another aspect of the present invention, the distance between the upper surface of the insulation substrate and the glass fiber layer is larger than the distance between the lower surface of the insulation substrate and the glass fiber layer. Thus, when the distance between the lower surface of the insulation substrate and the glass fiber layer is smaller, the location at which the diameter of the through hole becomes smallest is nearer to the lower surface of the insulation substrate, and the diameter of the lower-surface-side opening of the through hole is smaller. Therefore, since the diameter of the lower-surface-side land conductor can be reduced, wiring density can be further improved on the lower surface side of the insulation substrate.

In yet another aspect of the present invention, there is provided a method for producing a wiring substrate comprising at least one insulation layer, and at least one conductor layer stacked on the insulation layer, the method comprising a layered structure formation step, and a through hole provision step. In the layered structure formation step, there is formed a layered structure having a structure including an insulation substrate and a first metal layer stacked thereon. In the through hole provision step, there is provided a through hole penetrating at least the insulation substrate in a stacking direction through application of a laser beam to a surface of the layered structure on which the first metal layer is not formed. The insulation substrate has a structure including a first insulation layer, a second insulation layer, and a glass fiber layer provided between the first and second insulation layers. In the through hole provision step, application of the laser beam is terminated before penetration of the laser beam through the first metal layer.

In this wiring substrate production method, firstly, a laser beam is applied to a surface of the layered structure on which the first metal layer is not provided (hereinafter the surface may be referred to as "laser beam application surface"), to thereby provide, in the second insulation layer, a through hole having a diameter which decreases from the laser beam application surface toward the interior of the insulation substrate. This is because the amount of thermal energy received from the laser beam applied to the laser beam application surface decreases toward the interior of the insulation substrate. The previous and following description pertains to the case where the second insulation layer is provided on the side toward the laser beam application surface.

Since the glass fiber layer is provided between the first insulation layer and the second insulation layer, a region between the first and second insulation layers (hereinafter the region may be referred to as a "glass fiber region") is less likely to be melted through laser beam application, as compared with the first and second insulation layers. Therefore, the rate at which the through hole is provided (in a stacking direction) in the layered structure by laser beam application is lower in the glass fiber region than in the second insulation layer.

Thus, the diameter of a portion of the through hole penetrating the second insulation layer decreases from the laser beam application surface toward the interior of the insulation substrate; i.e., the portion assumes a truncated conical shape, by the time the through hole provided by laser beam application penetrates the glass fiber region.

Thereafter, when the laser beam applied via the laser beam application surface penetrates the glass fiber region, the laser beam is applied, through the second insulation layer and the glass fiber region, to the first insulation layer, whereby the through hole is provided in the first insulation layer from the glass fiber region toward the first metal layer until the laser beam penetrates the first insulation layer.

When the laser beam applied via the laser beam application surface penetrates the first insulation layer, the laser beam is applied, through the second and first insulation layers, to the first metal layer. Therefore, the thermal energy from the laser beam applied to the first metal layer is conducted to the first insulation layer via the first metal layer, whereby the diameter of a portion of the through hole penetrating the first insulation layer decreases from the first metal layer toward the interior of the insulation substrate; i.e., the portion assumes a truncated conical shape. This is because the amount of thermal energy from the first metal layer decreases toward the interior of the insulation substrate.

Then, laser beam application is terminated before penetration of the laser beam through the first metal layer. This is because when the laser beam penetrates the first metal layer, the amount of thermal energy received by the first metal layer from the laser beam becomes considerably lower than that before penetration of the laser beam through the first metal layer.

As described above, the through hole---whose diameter decreases from the first surface of the layered structure toward the interior thereof and increases from the interior toward the second surface of the layered structure---can be provided by laser beam application through the first surface of the layered structure.

In yet another aspect of the present invention, in the layered structure formation step, the layered structure is formed so as to have a second metal layer on the insulation substrate. The second metal layer may be employed as a wiring layer of the wiring substrate. In such a case, in the through hole provision step, the through hole is provided so as to penetrate the insulation substrate and the second metal layer. In addition, the second metal layer is formed so as to have a thickness smaller than that of the first metal layer, so that the laser beam is likely to penetrate the second metal layer, but is less likely to penetrate the first metal layer. Therefore, there is no requirement to carry out a process of increasing the irradiation energy of the laser beam so that the laser beam penetrates the second metal layer, and decreasing the irradiation energy of the laser beam after penetration of the laser beam through the second metal layer so that the laser beam encounters difficulty in penetrating the first metal layer. Thus, the irradiation energy of the laser beam can be maintained constant in the through hole provision step; i.e., the through hole provision step can be simplified.

In yet another aspect of the present invention, in the layered structure formation step, the layered structure is formed so as to have a second metal layer on the insulation substrate, and, before laser beam application in the through hole provision step, a penetration hole provision step is carried out for providing the second metal layer with a penetration hole through which the laser beam penetrates. Therefore, there is no requirement to carry out a process of increasing the irradiation energy of the laser beam so that the laser beam penetrates the second metal layer, and decreasing the irradiation energy of the laser beam after penetration of the laser beam through the second metal layer so that the laser beam encounters difficulty in penetrating the first metal layer. Thus, the irradiation energy of the laser beam can be maintained constant in the through hole provision step; i.e., the through hole provision step can be simplified.

### BRIEF DESCRIPTION OF THE DRAWINGS

[FIG. 1]

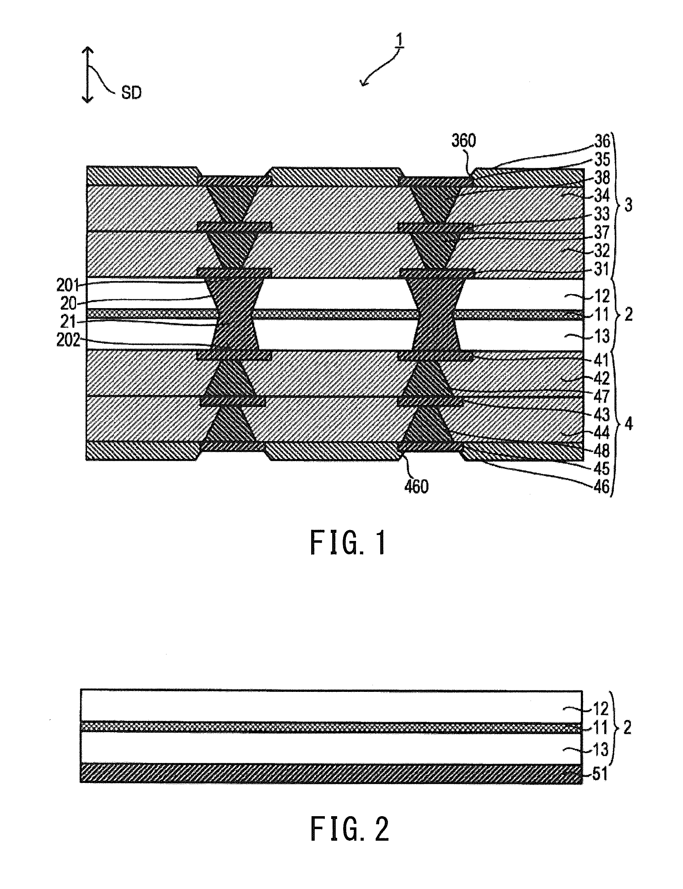

   FIG. 1 is a schematic cross-sectional view of the configuration of a multilayer wiring substrate 1 of a first embodiment.
[FIG. 2]
   FIG. 2 shows a process of producing the multilayer wiring substrate 1 of the first embodiment (first cross-sectional view).
[FIG. 3]

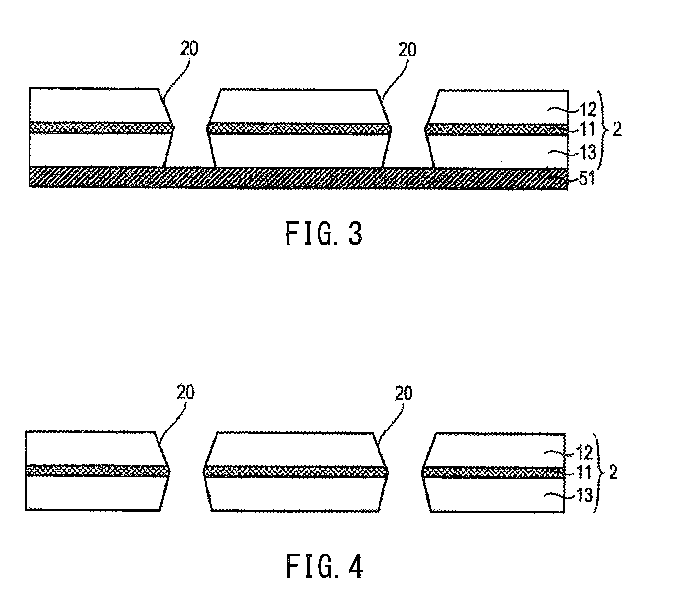

   FIG. 3 shows the process of producing the multilayer wiring substrate 1 of the first embodiment (second cross-sectional view).
[FIG. 4]
   FIG. 4 shows the process of producing the multilayer wiring substrate 1 of the first embodiment (third cross-sectional view).
[FIG. 5]

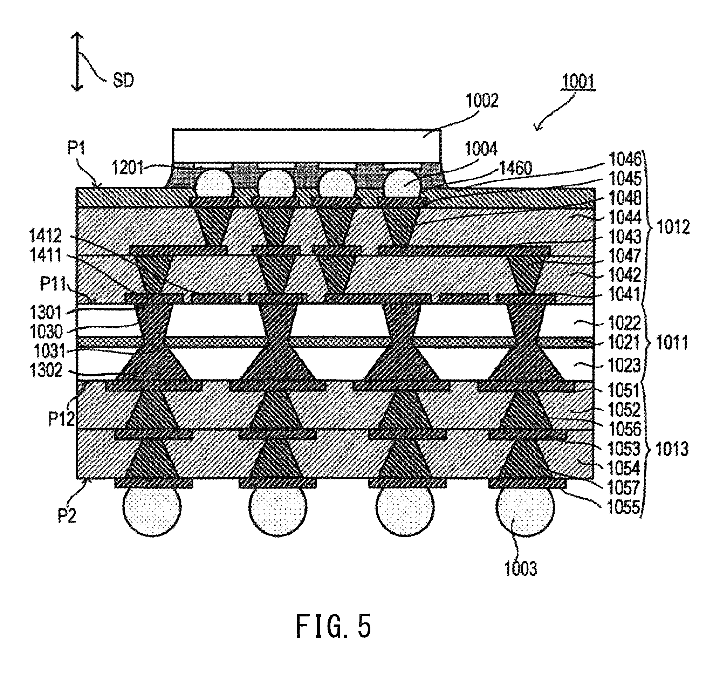

   FIG. 5 is a schematic cross-sectional view of the configuration of a multilayer wiring substrate 1001 of a second embodiment.
[FIG. 6]

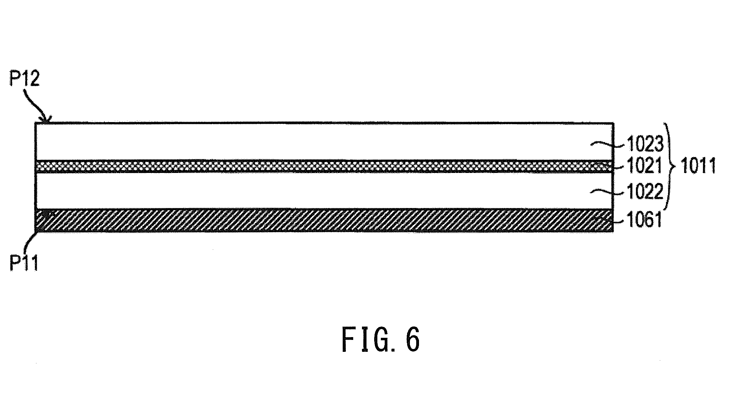

   FIG. 6 shows a process of producing the multilayer wiring substrate 1001 of the second embodiment (first cross-sectional view).
[FIG. 7]

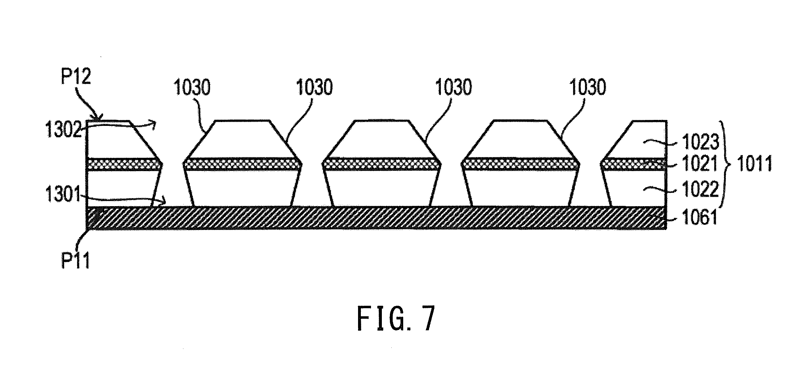

   FIG. 7 shows the process of producing the multilayer wiring substrate 1001 of the second embodiment (second cross-sectional view).
[FIG. 8]

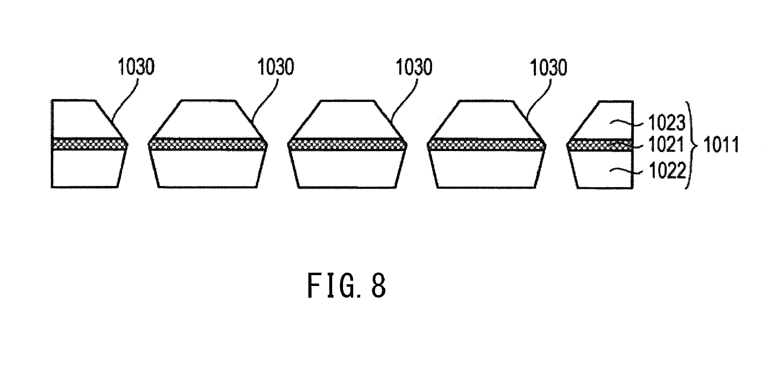

   FIG. 8 shows the process of producing the multilayer wiring substrate 1001 of the second embodiment (third cross-sectional view).
[FIG. 9]

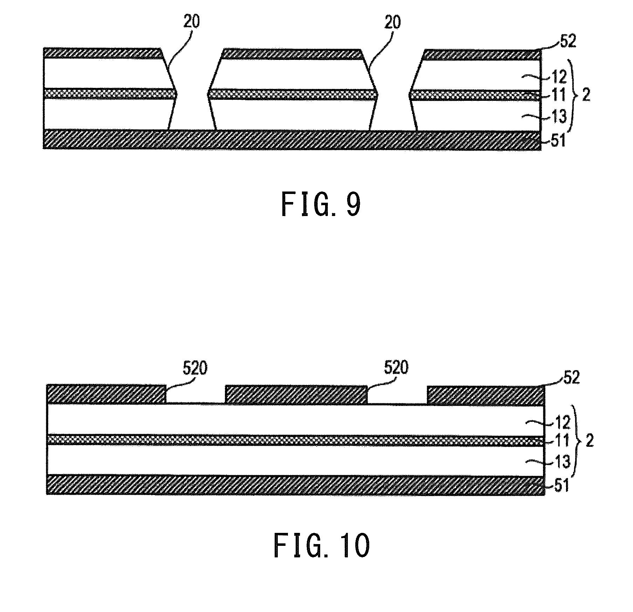

   FIG. 9 shows a process of producing a multilayer wiring substrate 1 of another embodiment (cross-sectional view).
[FIG. 10]
   FIG. 10 shows a process of producing a multilayer wiring substrate 1 of yet another embodiment (cross-sectional view).
[FIG. 11]

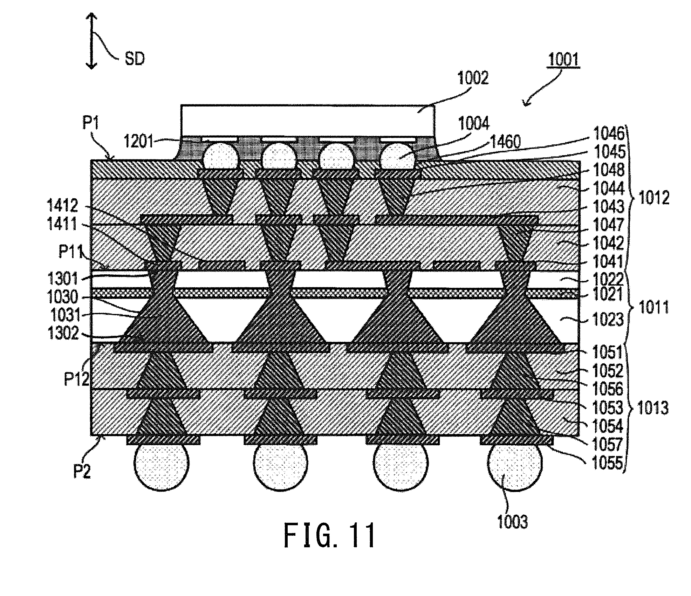

   FIG. 11 is a cross-sectional view of a multilayer wiring substrate 1001 of yet another embodiment.

### DESCRIPTION OF REFERENCE NUMERALS

1: multilayer wiring substrate
2: support layer
3, 4: build-up layer
11: glass fiber layer
12, 13: resin layer
20: through hole
21: through hole conductor
31, 33, 35, 41, 43, 45: conductor layer
32, 34, 42, 44: insulation layer
36, 46: solder resist layer
37, 38, 47, 48: via conductor
51, 52: metal layer
201, 202: opening
520: penetration hole
1001: multilayer wiring substrate
1002: IC chip
1003, 1004: bump
1011: support layer
1012, 1013: build-up layer
1021: glass fiber layer
1022, 1023: resin layer
1030: through hole
1031: through hole conductor
1041, 1043, 1045, 1051, 1053, 1055: conductor layer
1042, 1044, 1052, 1054: insulation layer
1046: solder resist layer
1047, 1048, 1056, 1057: via conductor
1061: metal layer
1201: connection terminal
1301, 1302: opening
1411: land conductor
1412: wiring conductor
1460: opening

### MODES FOR CARRYING OUT THE INVENTION

### (First embodiment)

A first embodiment of the present invention will next be described with reference to the drawings.

As shown in FIG. 1, a multilayer wiring substrate 1 of this embodiment to which the present invention is applied includes a support layer 2 and build-up layers 3 and 4, wherein the build-up layers 3 and 4 are respectively stacked on the upper and lower surfaces of the support layer 2 in a stacking direction SD.

The support layer 2 includes a glass fiber layer 11 and resin layers 12 and 13, wherein the resin layers 12 and 13 are respectively stacked on the upper and lower surfaces of the glass fiber layer 11.

The support layer 2 has through holes 20 penetrating therethrough. Each through hole 20 is filled with a through hole conductor 21. The diameter of the through hole 20 gradually decreases from the upper surface of the support layer 2 toward the glass fiber layer 11, and becomes smallest at the glass fiber layer 11. The diameter of the through hole 20 gradually increases from the glass fiber layer 11 toward the lower surface of the support layer 2.

The build-up layer 3 includes conductor layers 31, an insulation layer 32, conductor layers 33, an insulation layer 34, conductor layers 35, and a solder resist layer 36, the layers 31 to 36 being sequentially stacked. The conductor layers 31 are formed so as to cover upper-surface-side openings 201 of the through holes 20. Via conductors 37 and 38 extending in the stacking direction SD are respectively provided in the insulation layers 32 and 34. Thus, the conductor layers 31 are electrically connected to the conductor layers 33, and the conductor layers 33 are electrically connected to the conductor layers 35. The solder resist layer 36 has openings 360 in regions where the conductor layers 35 are provided.

The build-up layer 4 includes conductor layers 41, an insulation layer 42, conductor layers 43, an insulation layer 44, conductor layers 45, and a solder resist layer 46, the layers 41 to 46 being sequentially stacked. The conductor layers 41 are formed so as to cover lower-surface-side openings 202 of the through holes 20. Via conductors 47 and 48 extending in the stacking direction SD are respectively provided in the insulation layers 42 and 44. Thus, the conductor layers 41 are electrically connected to the conductor layers 43, and the conductor layers 43 are electrically connected to the conductor layer 45. The solder resist layer 46 has openings 460 in regions where the conductor layers 45 are provided.

Next will be described a method for producing the multilayer wiring substrate 1 to which the present invention is applied.

As shown in FIG. 2, firstly, a metal layer 51 (a copper layer in the present embodiment) is stacked on the lower surface of the support layer 2. Then, a laser beam is applied to specific positions on the upper surface of the support layer 2, to thereby provide the through holes 20 penetrating the support layer 2 as shown in FIG. 3. Laser beam application for provision of the through holes 20 is terminated before penetration of the laser beam through the metal layer 51.

Subsequently, as shown in FIG. 4, the metal layer 51 is removed through etching.

Thereafter, electroless plating is carried out, to thereby form thin electroless plating layers (copper layers in the present embodiment) on the wall surfaces of the through holes 20, and on the resin layers 12 and 13. Then, specific resist patterns corresponding to the wiring patterns of the conductor layers 31 and 41 are formed on the electroless plating layers. Subsequently, electroplating is carried out, to thereby form a plating layer (a copper layer in the present embodiment) on regions which are not covered with the resist patterns. Thereafter, unwanted electroless plating layers and resist patterns are removed through etching. Thus, as shown in FIG. 1, the through hole conductors 21 are formed in the through holes 20, and the conductor layers 31 and 41 having specific wiring patterns are formed.

Then, film-like resin materials (e.g., epoxy resin) are provided on opposite surfaces of the support layer 2, and the resin materials are cured through heating under vacuum, to thereby form the insulation layers 32 and 42. Thus, as shown in FIG. 1, the upper surface of the support layer 2 and the conductor layers 31 are covered with the insulation layer 32. Similarly, the lower surface of the support layer 2 and the conductor layers 41 are covered with the insulation layer 42.

Then, a laser beam is applied to specific positions on the surfaces of the insulation layers 32 and 42, to thereby provide a plurality of via holes in the insulation layers 32 and 42. Subsequently, a desmear treatment is carried out for removing smears generated in the thus-provided via holes. Thereafter, electroless plating is carried out, to thereby form thin electroless plating layers (copper layers in the present embodiment) on the insulation layers 32 and 42. Then, specific resist patterns corresponding to the wiring patterns of the conductor layers 33 and 43 are formed on the electroless plating layers. Subsequently, electroplating is carried out, to thereby form a plating layer (a copper layer in the present embodiment) on regions which are not covered with the resist patterns. Thereafter, unwanted electroless plating layers and resist patterns are removed through etching. Thus, as shown in FIG. 1, via conductors 37 and 47 are formed in the via holes, and the conductor layers 33 and 43 having specific wiring patterns are formed.

Subsequently, steps similar to those for forming the insulation layers 32 and 42, the conductor layers 33 and 43, and the via conductors 37 and 47 are carried out, to thereby form, as shown in FIG. 1, the insulation layers 34 and 44, the conductor layers 35 and 45, and via conductors 38 and 48 on the insulation layers 32 and 42.

Then, a solder resist containing an organic resin material (e.g., epoxy resin) is applied so as to cover the insulation layers 34 and 44 and the conductor layers 35 and 45, followed by patterning of the solder resist. Thus, as shown in FIG. 1, the solder resist layers 36 and 46 having the openings 360 and 460 in regions corresponding to the conductor layers 35 and 45 are formed on the insulation layers 34 and 44.

The production method for the multilayer wiring substrate 1 having the aforementioned configuration includes a layered structure formation step of forming a layered structure having a structure in which the metal layer 51 and the support layer 2 are sequentially stacked. The production method for the multilayer wiring substrate 1 also includes a through hole provision step of providing the through holes 20 penetrating the support layer 2 in the stacking direction SD through application of a laser beam to a surface of the layered structure on which the metal layer 51 is not formed. The support layer 2 has a structure including the resin layer 12, the resin layer 13, and the glass fiber layer 11 provided between the resin layers 12 and 13. In the through hole provision step, application of the laser beam is terminated before penetration of the laser beam through the metal layer 51.

Therefore, in the production method for the multilayer wiring substrate 1, firstly, a laser beam is applied to a surface of the support layer 2 on which the metal layer 51 is not provided (hereinafter the surface may be referred to as "laser beam application surface"), to thereby provide, in the resin layer 13, the through holes 20 each having a diameter which decreases from the laser beam application surface toward the interior of the support layer 2. This is because the amount of thermal energy received from the laser beam applied to the laser beam application surface decreases toward the interior of the support layer 2.

Since the glass fiber layer 11 is provided between the resin layer 12 and the resin layer 13, the glass fiber layer 11 between the resin layers 12 and 13 is less likely to be melted through laser beam application, as compared with the resin layers 12 and 13. Therefore, the rate at which the through hole 20 is provided (in the stacking direction SD) in the support layer 2 by laser beam application is lower in the glass fiber layer 11 than in the resin layer 13.

Thus, the diameter of a portion of the through hole 20 penetrating the resin layer 13 decreases from the laser beam application surface toward the interior of the support layer 2; i.e., the portion assumes a truncated conical shape, by the time the through hole 20 provided by laser beam application penetrates the glass fiber layer 11.

Thereafter, when the laser beam applied via the laser beam application surface penetrates the glass fiber layer 11, the laser beam is applied, through the resin layer 13 and the glass fiber layer 11, to the resin layer 12, whereby the through hole 20 is provided in the resin layer 12 from the glass fiber layer 11 toward the metal layer 51 until the laser beam penetrates the resin layer 12.

When the laser beam applied via the laser beam application surface penetrates the resin layer 12, the laser beam is applied, through the resin layers 12 and 13, to the metal layer 51. Therefore, the thermal energy from the laser beam applied to the metal layer 51 is conducted to the resin layer 12 via the metal layer 51, whereby the diameter of a portion of the through hole penetrating the resin layer 12 decreases from the metal layer 51 toward the interior of the support layer 2; i.e., the portion assumes a truncated conical shape. This is because the amount of thermal energy received from the metal layer 51 decreases toward the interior of the support layer 2.

Then, laser beam application is terminated before penetration of the laser beam through the metal layer 51. This is because when the laser beam penetrates the metal layer 51, the amount of thermal energy received by the metal layer 51 from the laser beam becomes considerably lower than that before penetration of the laser beam through the metal layer 51.

As described above, the through hole 20---whose diameter decreases from the first surface of the support layer 2 toward the interior thereof and increases from the interior toward the second surface of the support layer 2---can be provided by laser beam application through the first surface of the support layer 2.

In the description herein, the multilayer wiring substrate 1 corresponds to an example of the wiring substrate; the metal layer 51 corresponds to an example of the first metal layer; the support layer 2 corresponds to an example of the insulation substrate; the resin layer 12 corresponds to an example of the first insulation layer; the resin layer 13 corresponds to an example of the second insulation layer; and the glass fiber layer 11 corresponds to an example of the glass fiber layer.

### (Second embodiment)

A second embodiment of the present invention will next be described with reference to the drawings.

As shown in FIG. 5, a multilayer wiring substrate 1001 of the second embodiment to which the present invention is applied has, on a surface P1 thereof, an IC chip 1002. The multilayer wiring substrate 1001 is connected to another wiring substrate such as a motherboard (not shown) via bumps 1003 formed on a surface P2. Thus, the multilayer wiring substrate 1001 electrically connects the IC chip 1002 to another wiring substrate.

The multilayer wiring substrate 1001 includes a support layer 1011 and build-up layers 1012 and 1013, wherein the build-up layers 1012 and 1013 are respectively stacked on a surface P11 and a surface P12 of the support layer 1011 in a stacking direction SD.

The support layer 1011 includes a glass fiber layer 1021 and resin layers 1022 and 1023, wherein the resin layers 1022 and 1023 are respectively stacked on opposite surfaces of the glass fiber layer 1021. The resin layer 1022 is located on the side toward the surface P11, and the resin layer 1023 is located on the side toward the surface P12. The resin layer 1022 has a thickness equal to that of the resin layer 1023.

The support layer 1011 has through holes 1030 penetrating therethrough. Each through hole 1030 is filled with a through hole conductor 1031. The diameter of the through hole 1030 gradually decreases from the surface P11 of the support layer 1011 toward the glass fiber layer 1021, and becomes smallest at the glass fiber layer 1021. The diameter of the through hole 1030 gradually increases from the glass fiber layer 1021 toward the surface P12 of the support layer 1011. The opening 1301 of the through hole 1030 on the surface P11 side has a diameter smaller than that of the opening 1302 of the through hole 1030 on the surface P12 side.

The build-up layer 1012 includes conductor layers 1041, an insulation layer 1042, conductor layers 1043, an insulation layer 1044, conductor layers 1045, and a solder resist layer 1046, the layers 1041 to 1046 being sequentially stacked. The conductor layers 1041 include a plurality of land conductors 1411 formed so as to cover the openings 1301 (on the surface P11 side) of the through holes 1030, and a plurality of wiring conductors 1412 provided between the land conductors 1411.

Via conductors 1047 and 1048 extending in the stacking direction SD are respectively provided in the insulation layers 1042 and 1044. Thus, the conductor layers 1041 are electrically connected to the conductor layers 1043, and the conductor layers 1043 are electrically connected to the conductor layers 1045. The solder resist layer 1046 has openings 1460 in regions where the conductor layers 1045 are provided.

Bumps 1004 are formed on the conductor layers 1045 exposed through the openings 1460, and the bumps 1004 are connected to connection terminals 1201 of the IC chip 1002.

The build-up layer 1013 includes conductor layers 1051, an insulation layer 1052, conductor layers 1053, an insulation layer 1054, and conductor layers 1055, the layers 1051 to 1055 being sequentially stacked. The conductor layers 1051 are formed of land conductors formed so as to cover the openings 1302 (on the surface P12 side) of the through holes 1030. Hereinafter, the conductor layers 1051 covering the openings 1302 may be referred to as the "land conductors 1051." Via conductors 1056 and 1057 extending in the stacking direction SD are respectively provided in the insulation layers 1052 and 1054. Thus, the conductor layers 1051 are electrically connected to the conductor layers 1053, and the conductor layers 1053 are electrically connected to the conductor layers 1055. Bumps 1003 are formed on the conductor layers 1055.

Next will be described a method for producing the multilayer wiring substrate 1001 to which the present invention is applied.

As shown in FIG. 6, firstly, a metal layer 1061 (a copper layer in the present embodiment) is stacked on the surface P11 of the support layer 1011. Then, a laser beam is applied to specific positions on the surface P12 of the support layer 1011, to thereby provide, in the resin layer 1023, the through holes 1030 each having a diameter which decreases from the surface P12 toward the interior of the support layer 1011. This is because the amount of thermal energy received from the laser beam applied to the surface P12 decreases toward the interior of the support layer 1011.

Since the glass fiber layer 1021 is provided between the resin layer 1022 and the resin layer 1023, the glass fiber layer 1021 between the resin layers 1022 and 1023 is less likely to be melted through laser beam application, as compared with the resin layers 1022 and 1023. Therefore, the rate at which each through hole 1030 is provided (in the stacking direction SD) in the support layer 1011 by laser beam application is lower in the glass fiber layer 1021 than in the resin layer 1023.

Thus, the diameter of a portion of the through hole 1030 penetrating the resin layer 1023 decreases from the laser beam application surface toward the interior of the support layer 1011; i.e., the portion assumes a truncated conical shape, by the time the through hole 1030 provided by laser beam application penetrates the glass fiber layer 1021.

Thereafter, when the laser beam applied via the laser beam application surface penetrates the glass fiber layer 1021, the laser beam is applied, through the resin layer 1023 and the glass fiber layer 1021, to the resin layer 1022, whereby the through hole 1030 is provided in the resin layer 1022 from the glass fiber layer 1021 toward the metal layer 1061 until the laser beam penetrates the resin layer 1022.

When the laser beam applied via the laser beam application surface penetrates the resin layer 1022, the laser beam is applied, through the resin layers 1022 and 1023, to the metal layer 1061. Therefore, the thermal energy from the laser beam applied to the metal layer 1061 is conducted to the resin layer 1022 via the metal layer 1061, whereby the diameter of a portion of the through hole penetrating the resin layer 1022 decreases from the metal layer 1061 toward the interior of the support layer 1011; i.e., the portion assumes a truncated conical shape. This is because the amount of thermal energy received from the metal layer 1061 decreases toward the interior of the support layer 1011.

Then, laser beam application is terminated before penetration of the laser beam through the metal layer 1061. This is because when the laser beam penetrates the metal layer 1061, the amount of thermal energy received by the metal layer 1061 from the laser beam becomes considerably lower than that before penetration of the laser beam through the metal layer 1061.

Thus, as shown in FIG. 7, the through hole 1030---whose diameter decreases from the surface P12 of the support layer 1011 toward the interior thereof and increases from the interior toward the surface P11 of the support layer 1011---can be provided by laser beam application through the surface P12 of the support layer 1011.

Since the laser beam is applied through the surface P12 of the support layer 1011, the amount of thermal energy received by the surface P12 is larger than that received by the surface P11. Therefore, the diameter of the opening 1302 of the through hole 1030 on the surface P12 side becomes larger than that of the opening 1301 of the through hole 1030 on the surface P11 side.

Subsequently, as shown in FIG. 8, the metal layer 1061 is removed through etching.

Thereafter, electroless plating is carried out, to thereby form thin electroless plating layers (copper layers in the present embodiment) on the wall surfaces of the through holes 1030, and on the resin layers 1022 and 1023. Then, specific resist patterns corresponding to the wiring patterns of the conductor layers 1041 and 1051 are formed on the electroless plating layers. Subsequently, electroplating is carried out, to thereby form a plating layer (a copper layer in the present embodiment) on regions which are not covered with the resist patterns. Thereafter, unwanted electroless plating layers and resist patterns are removed through etching. Thus, as shown in FIG. 5, the through hole conductors 1031 are formed in the through holes 1030, and the conductor layers 1041 and 1051 having specific wiring patterns are formed. When the openings 1301 are provided so as to face the via conductors 1047 in the stacking direction SD, the diameter of the land conductor 1411 covering each of the openings 1301 is smaller than that of the land conductor 1051 facing the land conductor 1411 in the stacking direction SD.

Then, film-like resin materials (e.g., epoxy resin) are provided on opposite surfaces of the support layer 1011, and the resin materials are cured through heating under vacuum, to thereby form the insulation layers 1042 and 1052. Thus, as shown in FIG. 5, the surface P11 of the support layer 1011 and the conductor layer 1041 are covered with the insulation layer 1042. Similarly, the surface P12 of the support layer 1011 and the conductor layer 1051 are covered with the insulation layer 1052.

Then, a laser beam is applied to specific positions on the surfaces of the insulation layers 1042 and 1052, to thereby provide a plurality of via holes in the insulation layers 1042 and 1052. Subsequently, a desmear treatment is carried out for removing smears generated in the thus-provided via holes. Thereafter, electroless plating is carried out, to thereby form thin electroless plating layers (copper layers in the present embodiment) on the insulation layers 1042 and 1052. Then, specific resist patterns corresponding to the wiring patterns of the conductor layers 1043 and 1053 are formed on the electroless plating layers. Subsequently, electroplating is carried out, to thereby form a plating layer (a copper layer in the present embodiment) on regions which are not covered with the resist patterns. Thereafter, unwanted electroless plating layers and resist patterns are removed through etching. Thus, as shown in FIG. 5, via conductors 1047 and 1056 are formed in the via holes, and the conductor layers 1043 and 1053 having specific wiring patterns are formed.

Subsequently, steps similar to those for forming the insulation layers 1042 and 1052, the conductor layers 1043 and 1053, and the via conductors 1047 and 1056 are carried out, to thereby form, as shown in FIG. 5, the insulation layers 1044 and 1054, the conductor layers 1045 and 1055, and via conductors 1048 and 1057 on the insulation layers 1042 and 1052.

Then, a solder resist containing an organic resin material (e.g., epoxy resin) is applied so as to cover the insulation layer 1044 and the conductor layer 1045, followed by patterning of the solder resist. Thus, as shown in FIG. 5, the solder resist layer 1046 having the openings 1460 in regions corresponding to the conductor layers 1045 is formed on the insulation layer 1044.

The thus-configured multilayer wiring substrate 1001 includes the support layer 1011 having a structure in which the glass fiber layer 1021 is provided between the resin layer 1022 and the resin layer 1023. The multilayer wiring substrate 1001 has the through holes 1030 each having a diameter which decreases from the surface P12 of the support layer 1011 toward the interior of the support layer 1011, which becomes smallest at the glass fiber layer 1021, and which increases from the glass fiber layer 1021 toward the surface P11 of the support layer 1011. The multilayer wiring substrate 1001 includes the land conductors 1051 formed so as to cover the openings 1302 (on the surface P12 side) of the through holes 1030. The multilayer wiring substrate 1001 also includes the land conductors 1411 formed so as to cover the openings 1301 (on the surface P11 side) of the through holes 1030. The multilayer wiring substrate 1001 includes the through hole conductors 1031 formed in the through holes 1030 for electrically connecting the land conductors 1051 to the land conductors 1411. The diameter of the opening 1302 of the through hole 1030 on the surface P12 side is larger than that of the opening 1301 of the through hole 1030 on the surface P11 side, and the diameter of the land conductor 1051 is larger than that of the land conductor 1411.

As described above, the support layer 1011 has a structure including the glass fiber layer 1021 provided between the resin layer 1022 and the resin layer 1023. Therefore, the through hole 1030---whose diameter decreases from the surface P12 of the support layer 1011 toward the interior thereof, becomes smallest at the glass fiber layer 1021, and increases from the glass fiber layer 1021 toward the surface P11 of the support layer 1011---can be provided by applying a laser beam to the surface P12 of the support layer 1011.

Thus, a portion of the through hole 1030, the portion being located above the glass fiber layer 1021 and on the surface P12 side, is not misaligned with respect to a portion of the through hole 1030, the portion being located below the glass fiber layer 1021 and on the surface P11 side. Therefore, since the aforementioned misalignment is not required to be taken into consideration, neither the land conductor 1051 for covering the opening 1302 (on the surface P12 side) of the through hole 1030, nor the land conductor 1411 for covering the opening 1301 (on the surface P11 side) of the through hole 1030 is required to be formed to have a large size.

The diameter of each land conductor, which covers the corresponding opening of the through hole 1030, is adjusted to become slightly larger than that of the opening of the through hole. Thus, the diameter of the land conductor 1411 can be made smaller than that of the land conductor 1051.

As described above, there is no requirement to take into consideration misalignment between the land conductor on the surface P12 side and the land conductor on the surface P11 side of the support layer 1011. Furthermore, since the diameter of the land conductor on the surface P11 side can be made smaller than that of the land conductor on the surface P12 side, wiring density can be improved on the surface P11 side of the support layer 1011.

The multilayer wiring substrate 1001 has a plurality of the through holes 1030, and the land conductors 1411 and 1051 corresponding to each of the through holes 1030. On the surface P11 of the support layer 1011, the wiring conductor 1412 is formed between at least two adjacent land conductors 1411.

Thus, a region between the two land conductors 1411 can be effectively employed for wiring, and wiring density can be improved on the surface P11 side of the support layer 1011.

The multilayer wiring substrate 1001 includes, on the surface P11 side of the support layer 1011, the bumps 1004 for connecting the wiring substrate to the IC chip 1002. In the multilayer wiring substrate 1001, since the diameter of the land conductor 1411 is smaller than that of the land conductor 1051, the degree of freedom of wiring layout is higher on the surface P11 side of the support layer 1011 than on the surface P12 side thereof. Therefore, the degree of integration of connection terminals---which are provided on the multilayer wiring substrate 1001 for connecting the multilayer wiring substrate 1001 to the IC chip 1002---is more likely to be improved on the surface P11 side of the support layer 1011 than on the surface P12 side thereof. Since the multilayer wiring substrate 1001 is employed for electrically connecting the IC chip 1002 to another wiring substrate, the degree of integration of connection terminals is higher on the surface on which the IC chip 1002 is mounted than on the surface which is connected to another wiring substrate.

In the multilayer wiring substrate 1001, a portion of the through hole 1030, the portion being located on the surface P12 side with respect to the glass fiber layer 1021 (hereinafter the portion may be referred to as "surface P12-side portion"), has a cross-sectional area larger than that of a portion of the through hole 1030, the portion being located on the surface P11 side with respect to the glass fiber layer 1021 (hereinafter the portion may be referred to as "surface P11-side portion"). Thus, the surface P12-side portion of the through hole 1030 has a heat capacity larger than that of the surface P11-side portion of the through hole 1030. Therefore, heat generated in the IC chip 1002 mounted on the surface P11-side portion is readily released, via the through hole 1030, toward the surface P12 of the support layer 1011, and the heat release performance of the IC chip 1002 can be improved.

In the description herein, the multilayer wiring substrate 1001 corresponds to an example of the wiring substrate; the support layer 1011 corresponds to an example of the insulation substrate; the resin layer 1022 corresponds to an example of the first insulation layer; the resin layer 1023 corresponds to an example of the second insulation layer; the glass fiber layer 1021 corresponds to an example of the glass fiber layer; the surface P12 corresponds to an example of the upper surface; the surface P11 corresponds to an example of the lower surface; the land conductor 1051 corresponds to an example of the upper-surface-side land conductor; the land conductor 1411 corresponds to an example of the lower-surface-side land conductor; the wiring conductor 1412 corresponds to an example of the wire; and the bump 1004 corresponds to an example of the connection terminal.

Although one embodiment of the present invention has been described above, the present invention is not limited to the embodiment, and various embodiments may be carried out so long as they fall within the technical scope of the invention.

For example, in the above-described first embodiment, the metal layer 51 is stacked on the lower surface of the support layer 2. However, as shown in FIG. 9, a metal layer 52 may be further stacked on the support layer 2. Thus, the metal layer 52 can be employed as a wiring layer of the multilayer wiring substrate 1. Then, through holes 20 penetrating the support layer 2 and the metal layer 52 are provided by laser beam application. In this case, the metal layer 51 is formed so as to have a thickness larger than that of the metal layer 52, so that the laser beam is likely to penetrate the metal layer 52, but is less likely to penetrate the metal layer 51. Therefore, there is no requirement to carry out a process of increasing the irradiation energy of the laser beam so that the laser beam penetrates the metal layer 52, and decreasing the irradiation energy of the laser beam after penetration of the laser beam through the metal layer 52 so that the laser beam encounters difficulty in penetrating the metal layer 51. Thus, the irradiation energy of the laser beam can be maintained constant in the step of providing the through holes 20; i.e., this step can be simplified.

When the metal layer 52 is further stacked on the support layer 2, as shown in FIG. 10, before laser beam application in the step of providing the through holes 20, penetration holes 520 for causing the laser beam to penetrate therethrough may be provided in the metal layer 52. In this case, the irradiation energy of the laser beam can be maintained constant in the step of providing the through holes 20; i.e., this step can be simplified.

In the above-described second embodiment, the resin layer 1022 has a thickness equal to that of the resin layer 1023, and the distance between the surface P12 of the support layer 1011 and the glass fiber layer 1021 is equal to the distance between the surface P11 of the support layer 1011 and the glass fiber layer 1021. However, as shown in FIG. 11, the resin layer 1022 may have a thickness smaller than that of the resin layer 1023, and the distance between the surface P12 of the support layer 1011 and the glass fiber layer 1021 may be larger than the distance between the surface P11 of the support layer 1011 and the glass fiber layer 1021.

Thus, when the distance between the surface P11 of the support layer 1011 and the glass fiber layer 1021 is smaller, the location at which the diameter of the through hole 1030 becomes smallest is nearer to the surface P11 of the support layer 1011, and the diameter of the opening 1301 of the through hole 1030 on the surface P11 side is smaller. Therefore, since the diameter of the land conductor 1411 can be reduced, wiring density can be further improved on the surface P11 side of the support layer 1011.

In the above-described second embodiment, the metal layer 1061 is stacked on the lower surface of the support layer 1011. However, a metal layer may be further stacked on the upper surface of the support layer 1011. Thus, the upper-surface metal layer can be employed as a wiring layer of the multilayer wiring substrate 1001. Then, through holes penetrating the support layer 1011 and the upper-surface metal layer are provided by laser beam application. In this case, the metal layer 1061 is formed so as to have a thickness larger than that of the upper-surface metal layer, so that the laser beam is likely to penetrate the upper-surface metal layer, but is less likely to penetrate the metal layer 1061. Therefore, there is no requirement to carry out a process of increasing the irradiation energy of the laser beam so that the laser beam penetrates the upper-surface metal layer, and decreasing the irradiation energy of the laser beam after penetration of the laser beam through the upper-surface metal layer so that the laser beam encounters difficulty in penetrating the metal layer 1061. Thus, the irradiation energy of the laser beam can be maintained constant in the step of providing the through holes; i.e., this step can be simplified.

When the upper-surface metal layer is further stacked on the support layer 1011, before laser beam application in the step of providing the through holes, penetration holes for causing the laser beam to penetrate therethrough may be provided in the upper-surface metal layer. In this case, the irradiation energy of the laser beam can be maintained constant in the step of providing the through holes; i.e., this step can be simplified.

## Claims

1. A wiring substrate comprising:
an insulation substrate having a structure including a first insulation layer, a second insulation layer, and a glass fiber layer provided between the first insulation layer and the second insulation layer;
a through hole provided in the insulation substrate and having a diameter which decreases from one of opposite surfaces of the insulation substrate, defined as an upper surface, toward the interior thereof, which becomes smallest at the glass fiber layer, and which increases from the glass fiber layer toward the other of opposite surfaces of the insulation substrate, defined as a lower surface;
an upper-surface-side land conductor formed so as to cover an upper-surface-side opening of the through hole;
a lower-surface-side land conductor formed so as to cover a lower-surface-side opening of the through hole; and
a through hole conductor formed in the through hole so as to electrically connect the upper-surface-side land conductor with the lower-surface-side land conductor, wherein the upper-surface-side opening of the through hole has a diameter larger than that of the lower-surface-side opening of the through hole; and
the upper-surface-side land conductor has a diameter larger than that of the lower-surface-side land conductor.

2. A wiring substrate according to claim 1, which comprises:
a plurality of the through holes; and
an upper-surface-side land conductor corresponding to each of the through holes, and a lower-surface-side land conductor corresponding to each of the through holes, wherein, on the lower surface of the insulation substrate, a wire is formed between at least two adjacent lower-surface-side land conductors.

3. A wiring substrate according to claim 1 or 2, which comprises, on the lower surface side of the insulation substrate, a connection terminal for connecting the wiring substrate to an IC chip.

4. A wiring substrate according to any one of claims 1 to 3, wherein the through hole has an upper-surface-side portion located above the glass fiber layer, and a lower-surface-side portion located below the glass fiber layer; and
the upper-surface-side portion has a cross-sectional area larger than that of the lower-surface-side portion.

5. A wiring substrate according to any one of claims 1 to 4, wherein the distance between the upper surface of the insulation substrate and the glass fiber layer is larger than the distance between the lower surface of the insulation substrate and the glass fiber layer.

6. A method for producing a wiring substrate comprising at least one insulation layer, and at least one conductor layer stacked on the insulation layer, the method comprising:
a layered structure formation step of forming a layered structure having a structure including an insulation substrate and a first metal layer stacked thereon; and
a through hole provision step of providing a through hole penetrating at least the insulation substrate in a stacking direction through application of a laser beam to a surface of the layered structure on which the first metal layer is not formed, wherein the insulation substrate has a structure including a first insulation layer, a second insulation layer, and a glass fiber layer provided between the first insulation layer and the second insulation layer; and
in the through hole provision step, application of the laser beam is terminated before penetration of the laser beam through the first metal layer.

7. A method for producing a wiring substrate according to claim 6, wherein, in the layered structure formation step, the layered structure is formed so as to have a second metal layer on the insulation substrate;
in the through hole provision step, the through hole is provided so as to penetrate the insulation substrate and the second metal layer; and
the second metal layer is formed so as to have a thickness smaller than that of the first metal layer.

8. A method for producing a wiring substrate according to claim 6 or 7, wherein, in the layered structure formation step, the layered structure is formed so as to have a second metal layer on the insulation substrate; and
before laser beam application in the through hole provision step, a penetration hole provision step is carried out for providing the second metal layer with a penetration hole through which the laser beam penetrates.
